(19) Europäisches Patentamt / European Patent Office / Office européen des brevets

(11) **EP 4 553 575 A1**

(12) **EUROPEAN PATENT APPLICATION**

(43) Date of publication:
**14.05.2025 Bulletin 2025/20**

(21) Application number: **23209193.4**

(22) Date of filing: **10.11.2023**

(51) International Patent Classification (IPC):
**G03F 1/24** *(2012.01)*    **G03F 1/54** *(2012.01)*
**G03F 7/20** *(2006.01)*

(52) Cooperative Patent Classification (CPC):
**G03F 1/24; G03F 1/54; G03F 7/70091;**
**G03F 7/70433**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Imec VZW**
**3001 Leuven (BE)**

(72) Inventors:
• **PELLENS, Nick**
  **3110 Rotselaar (BE)**
• **PHILIPSEN, Vicky**
  **3080 Tervuren (BE)**

(74) Representative: **Winger**
**Mouterij 16 bus 101**
**3190 Boortmeerbeek (BE)**

(54) **EXTREME ULTRAVIOLET LITHOGRAPHY MASK**

(57)    An extreme ultraviolet lithography mask (1), the mask (1) comprising:
- a multi-layer reflector (11), and
- a patterned absorber layer (12) positioned over the multi-layer reflector (11),
wherein the absorber layer (12) has a thickness (t) between 15 to 35 nm and a refractive index of at most 0.93.

FIG. 2A

## Description

### Technical field of the invention

The present invention relates to the field of extreme ultraviolet lithography. More particularly, the present invention relates to devices, systems and methods for performing extreme ultraviolet lithography.

### Background of the invention

Because of the short wavelength of extreme ultraviolet radiation, extreme ultraviolet lithography setups typically employ reflective optics, implying oblique illumination of the extreme ultraviolet lithography mask. An extreme ultraviolet lithography mask, also referred to as a reticle, therefore comprises a mirror, typically a multi-layer reflector, and a patterned absorber layer on the multi-layer reflector. During a lithography process, the mask is situated between an extreme ultraviolet radiation source and a substrate, typically a semiconductor wafer, comprising a photoresist, so that extreme ultraviolet radiation from the source is reflected by the mask to form an image of the absorber layer pattern on the photoresist to pattern the photoresist.

Mask 3D effects arise from the finite, or non-zero, thickness of the patterned absorber layer of the mask utilized in the lithographic process. These mask 3D effects, provoked by the oblique angle of incidence of the extreme ultraviolet radiation on the 3D mask, result in shadowing effects and imperfect diffraction. Mask 3D effects result in contrast fading, feature-dependent best focus shifts, and telecentricity errors. These effects can result in unintended, and typically unwanted, disparities between the absorber layer pattern and the pattern imprinted in the photoresist. Therefore, the critical dimensions of the features may not be accurately reproduced or may be more prone to stochastic failures, leading to reduced pattern accuracy and decreased chip performance. Consequently, mask 3D effects reduce the process window of operation for lithography steps and increase defectivity during chip manufacturing. Due to the small process window and stochastic failures associated with imaging small mask features, extreme ultraviolet lithography cannot yet be pushed to low k1 imaging processes.

The extreme ultraviolet radiation source used during the lithography process also contributes to mask 3D effects. An optimized source for extreme ultraviolet lithography contains multiple poles to limit pattern placement errors through defocus. The different poles of a multipolar extreme ultraviolet radiation source are typically incident on the mask at a different angle of incidence, and different poles typically produce extreme ultraviolet radiation having different polarization states. The use of a multipolar extreme ultraviolet source may result in imperfections in the diffraction pattern originating from these mask 3D effects, including monopole diffraction amplitude imbalances, pole-to-pole phase offsets or image shifts, and pole-to-pole aerial image amplitude imbalance.

As such, at the critical mask dimensions of future technology nodes, lithography steps are expected to be challenging due to mask 3D effects. As a result, increased defectivity during lithography steps in the chip manufacturing process may be expected, reducing chip yield.

There is thus still a need in the art for extreme ultraviolet lithography masks and methods using these masks that address at least some of the above problems.

### Summary of the invention

It is an object of the present invention to provide an extreme ultraviolet lithography mask, an extreme ultraviolet lithography setup comprising said mask, and a method of patterning a photoresist using said mask, addressing at least some of the above problems.

The above objective is accomplished by a method and apparatus according to the present invention.

It is an advantage of embodiments of the present invention that the contrast that may be achieved with the extreme ultraviolet lithography mask may be high. It is an advantage of embodiments of the present invention that 3D mask effects, such as contrast fading, through-focus pattern or image shifts and best focus shifts, may be mitigated. Therefore, embodiments of the present invention may decrease defectivity and increase throughput of (high-numerical aperture) extreme-ultraviolet lithography processes. Given a larger process window and reduced stochastic failures, embodiments of the present invention may push lithography steps during chip manufacturing to lower k1 imaging processes.

It is an advantage of embodiments of the present invention that, as the thickness of the absorber layer of the extreme ultraviolet lithography mask may be small, the reflectivity of the mask may be high, so that the dose of extreme ultraviolet radiation needed for extreme ultraviolet lithography is low.

In a first aspect, the present invention relates to an extreme ultraviolet lithography mask, the mask comprising:

- a multi-layer reflector, and
- a patterned absorber layer positioned over the multi-layer reflector,

wherein the absorber layer has a thickness between 15 to 35 nm and a refractive index of at most 0.93.

In some embodiments, the refractive index is at most 0.92, such as for example at most 0.91, or such as for example at most 0.90, or such as for example at most 0.89. The contrast may be particularly high when the absorber layer has a low refractive index. For example, the refractive index may be between 0.85 to 0.93, such as between 0.87 and 0.92, or between 0.87 and 0.90. Said refractive index may be that at a wavelength between 5 and 40 nm, e.g. at a wavelength of 13.5 nm, which is often used for extreme ultraviolet lithography.

The absorber layer may be formed of materials having a refractive index of at most 0.93, such as for example, Pt, PtMo, $Pt_2Mo$, RuTa, RusTa, Mo, or RusRe. Further examples are Ru or RusW. However, the invention is not limited to these materials.

In some embodiments, the absorber layer has a thickness between 15 and 30 nm, e.g., a thickness between 20 and 25 nm. The contrast that may be achieved may be particularly high when the absorber layer has a thickness within these ranges.

In a second aspect, the present invention relates to an extreme ultraviolet lithography setup. The setup comprises the extreme ultraviolet lithography mask according to embodiments of the first aspect of the present invention. The setup comprises a multipolar extreme ultraviolet radiation source. The setup further comprises a table for holding a substrate comprising a photoresist to be patterned. The setup is configured for exposing poles of the multipolar extreme ultraviolet radiation source, so that extreme ultraviolet radiation from each pole is reflected by the mask to form an image of the absorber layer pattern on the photoresist, when present, to pattern the photoresist. The setup is adapted for compensating for an image shift between images formed by different poles, said image shift resulting from a different angle of incidence and/or polarity of the extreme ultraviolet radiation from different poles onto the mask.

In embodiments, the multipolar extreme ultraviolet radiation source is adapted for controlling the irradiation intensity to be within 0.8 times and 1.0 times $I_0$, with $I_0$ being given by:

$$I_0 = I_{\text{conventional absorber thickness}} \cdot \exp\left[\frac{8\pi k}{\lambda}\left(t_{\text{absorber}} - t_{\text{absorber,conventional}}\right)\right].$$

Said irradiation intensity may be the irradiation intensity incident on the mask. Herein, $t_{\text{absorber}}$ is the thickness of the absorber layer of the extreme ultraviolet lithography mask according to embodiments of the first aspect of the present invention; $t_{\text{absorber, conventional}}$ is the thickness of a conventional absorber layer, e.g., a conventional absorber layer having a thickness of 60 nm and being formed of tantalum; $I_{\text{conventional absorber thickness}}$ is the irradiation intensity or exposure dose used in case of the conventional absorber layer having the thickness $t_{\text{absorber, conventional}}$; k is the extinction coefficient of the absorber layer of the extreme ultraviolet lithography mask according to embodiments of the first aspect of the present invention at wavelength $\lambda$; and $\lambda$ is the wavelength of the extreme ultraviolet radiation. The $I_{\text{conventional absorber thickness}}$ may depend on the lithography system that is used, so that $I_0$ may depend on the lithography system that is used as well. However, $I_{\text{conventional absorber thickness}}$ is typically in the range between 20 and 100 $mJ/cm^2$, e.g., it may be 30 $mJ/cm^2$, on the mask.

The multipolar extreme ultraviolet radiation source may be any type of extreme ultraviolet radiation source having at least two poles, e.g., a dipolar, a quadrupolar or an octupolar extreme ultraviolet radiation source. That is, the multipolar extreme ultraviolet radiation source may be decomposed in a plurality of poles or sets of at least one pole, e.g., in a plurality of monopoles. The different poles of the extreme ultraviolet radiation source typically generate extreme ultraviolet radiation having a different polarization state. Furthermore, the different poles of the extreme ultraviolet radiation source are typically spatially shifted with respect to each other, so that the angle of incidence of radiation from the different poles onto the mask may be different. This may result in said image shift between images formed by different poles.

Any technique for compensating for said image shift may be applied.

In embodiments, the setup being adapted for compensating for said image shift may comprise that the extreme ultraviolet radiation source is optimized for compensating, or minimizing, for the image shift. This way of compensating for the image shift is described in Franke, Joern-Holger, et al. "Improving exposure latitudes and aligning best focus through pitch by curing M3D phase effects with controlled aberrations." International Conference on Extreme Ultraviolet Lithography 2019. Vol. 11147. SPIE, 2019. Said optimization of the source may comprise that the source is provided with an adapted pupil shape, and that the radiation from the source may be provided with an aberration. Said aberration may be introduced by an extreme ultraviolet radiation source that is asymmetric by design. However, due to the angle-specific nature of mask 3D effects (which are significant for the thin, low refractive index absorber layers), source asymmetry is likely to result in pole-specific mask 3D effects, which may be difficult to compensate by controlled aberrations.

In preferred embodiments, the setup being adapted for compensating for said image shift preferably comprises that the setup is adapted for performing split pole exposure lithography. Said split pole exposure lithography is, for example, described in Franke, Joern-Holger, Timothy A. Brunner, and Eric Hendrickx. "Dual monopole exposure strategy to improve extreme ultraviolet imaging." Journal of Micro/Nanopatterning, Materials, and Metrology 21.3 (2022):

030501-030501. In these embodiments, the setup may comprise a controller adapted to consecutively expose a different set of at least one pole of the multipolar extreme ultraviolet radiation source, said compensating for said image shift comprising optimizing an alignment of the radiation with respect to the photoresist between consecutive exposures. When the multipolar extreme ultraviolet radiation source comprises more than two poles, the set may comprise two or more poles of the multipolar extreme ultraviolet radiation source, wherein the controller may be adapted to expose the two or more poles within each set simultaneously.

Different sets of at least one pole typically comprise different poles amongst the poles of the multipolar extreme ultraviolet radiation source. Each of the different sets of at least one pole may comprise an equal number of poles, or in other words, the poles of the source may be equally divided amongst the plurality of sets. For example, the two poles of a dipolar extreme ultraviolet radiation source may be divided over two sets of poles, so that each set comprises one of the two poles. As another example, the four poles of a quadrupolar extreme ultraviolet radiation source may be divided over two sets of poles, so that each set comprises two of the four poles. Alternatively, said four poles may be divided over four sets of poles, so that each pole set comprises one of the four poles.

Any optical component of the setup may be moved to optimize said alignment. Preferably, the controller may be adapted to move the extreme ultraviolet lithography mask to optimize said alignment. The controller may be adapted to move the table for holding a substrate comprising a photoresist to be patterned to optimize said alignment. The controller may be adapted to move the extreme ultraviolet source and/or any optical component, e.g., mirror, for directing the radiation from the source to the mask and from the mask to the photoresist to be patterned, to optimize said alignment. Said movement may be performed between consecutive exposures, so that a good overlap between images produced in consecutive exposures may be obtained.

In a third aspect, the present invention relates to a method of patterning a photoresist. The method comprises performing lithography by exposing poles of an extreme ultraviolet radiation source, so that extreme ultraviolet radiation from each pole is reflected by the extreme ultraviolet lithography mask according to any embodiments of the first aspect of the present invention, to form an image of the absorber layer pattern on a photoresist to pattern the photoresist. The method comprising compensating for an image shift between images formed by different poles, said image shift resulting from a different angle of incidence and/or polarity of the extreme ultraviolet radiation from different poles onto the mask. Said image shift may result from mask 3D effects.

Any technique for compensating for said image shift may be applied. The technique may comprise determining the image shift, or obtaining a predetermined image shift, between different poles of the source. The technique may comprise modifying features of the setup to compensate for, or reduce, the image shift. Determining the image shift may be performed in any way known to the skilled person, for example, by theoretical modelling or experimental detection. In embodiments, a controller of the setup may be adapted to determine the shift, or a device external to the setup, e.g., when designing the setup, may be used to determine the shift.

Determining how the image shift may be best compensated for, may be performed by modifying features of the setup differently for lithography performed on different dies on a wafer, and determining which die has the optimal, e.g., minimal, image shift. Compensating for the image shift, in the method in accordance with embodiments of the present invention, may then be performed in the same way as it was performed on the die with the optimal image shift.

In embodiments, the features that may be modified may be the extreme ultraviolet radiation source, e.g., a pupil or an aberration introduced into radiation from the source may be optimized, optimized for compensating for, e.g., minimizing, said image shift. In these embodiments, optimization may be performed when designing the setup, so that the setup may comprise an optimized extreme ultraviolet radiation source.

In embodiments, modifying features of the setup may comprise adapting or optimizing an alignment of the setup, e.g., in split pole exposure lithography, for compensating for said image shift. In embodiments, modifying features of the setup may comprise configuring the controller, based on the determined image shift, for optimizing said alignment of the setup, or for performing split pole exposure lithography, for compensating for said image shift. Alternatively, the controller may be preconfigured, e.g., during installation of the setup, for optimizing said alignment of the setup, or for performing split pole exposure lithography, for compensating for said image shift.

The mask of the present invention is particularly well suited when the different poles of the multipolar extreme ultraviolet source are exposed, not all at once, but consecutively in sets of at least one pole, i.e., when used in a split pole exposure technique. Preferably, said performing lithography comprises performing split pole exposure lithography, comprising consecutively exposing a different set of at least one pole of the multipolar extreme ultraviolet radiation source, said compensating for said image shift comprising optimizing an alignment of the radiation with respect to the photoresist between consecutive exposures. Preferably, optimizing said alignment comprises shifting a position of the mask between consecutive exposures of different poles.

In embodiments, said extreme ultraviolet radiation is incident onto the mask at an intensity of between 0.8 times and 1.0 times $I_0$, with $I_0$ being given by:

$$I_0 = I_{conventional\ absorber\ thickness} \cdot \exp\left[\frac{8\pi k}{\lambda}\left(t_{absorber} - t_{absorber,conventional}\right)\right].$$

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

FIG. 1 is a schematic representation of a vertical cross-section of a mask in accordance with embodiments of the first aspect of the present invention.

FIG. 2A is a schematic representation of a lithography setup in accordance with embodiments of the second aspect of the present invention.

FIG. 2B is a front view of a multipolar extreme ultraviolet source that may be used in the lithography setup.

FIG. 3A and FIG. 3B are plots of images, plotted as radiation intensity as a function of position, of the patterned absorber layer on the photoresist.

FIG. 4A and FIG. 4B are plots of the contrast as a function of thickness of the absorber layer, for an absorber layer formed of Ta and of a material having a refractive index of 0.90, respectively.

FIG. 5A and FIG. 5B are plots of the NILS as a function of thickness of the absorber layer for dipolar radiation and monopolar radiation, respectively, for absorber layers formed of materials having a wide range of refractive indexes n.

FIG. 6 is a plot of the absolute absorber reflectivity as a function of thickness of the absorber layer, for absorber layers formed of materials having a wide range of extinction coefficients.

In the different figures, the same reference signs refer to the same or analogous elements.

**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

Where in embodiments of the present invention reference is made to optimizing or optimisation, reference is made to "making an improvement with respect to a conventional or existing situation". Such an improvement may result in an optimum or merely in an improvement, whereby further improvement is still possible, e.g. by tuning other conditions.

In a first aspect, the present invention relates to an extreme ultraviolet lithography mask. Such mask typically is for use in extreme ultraviolet lithography. The mask comprises a multi-layer reflector and a patterned absorber layer positioned over the multi-layer reflector. According to embodiments of the present invention, the absorber layer has a thickness (t) between 15 to 35 nm, for example a thickness between 15 and 30nm, and a refractive index of at most 0.93. Such absorber layers may be formed for example of Pt, PtMo, Pt2Mo, RuTa, Ru3Ta, Mo, or Ru3Re.

In another aspect, the present invention relates to an extreme ultraviolet lithography system comprising such a mask described in the first aspect. Such an extreme ultraviolet lithography system may comprise a multipolar extreme ultraviolet radiation source, and a table for holding a substrate comprising a photoresist to be patterned. The setup may be configured for exposing poles of the multipolar extreme ultraviolet radiation source, so that extreme ultraviolet radiation from each pole is reflected by the mask to form an image of the absorber layer pattern on the photoresist, when present, to pattern the photoresist. The setup furthermore is adapted for compensating for an image shift ($\delta x$) between images formed by different poles, said image shift ($\delta x$) resulting from a different angle of incidence and/or polarity of the extreme ultraviolet radiation from different poles onto the mask.

The multipolar extreme ultraviolet radiation source may be adapted for controlling the irradiation intensity to be within 0.8 times and 1.0 times $I_0$, with $I_0$ being given by:

$$I_0 = I_{conventional\ absorber\ thickness} \cdot \exp\left[\frac{8\pi k}{\lambda}\left(t_{absorber} - t_{absorber,conventional}\right)\right].$$

In some embodiments, a controller may be present for controlling the multipolar extreme ultraviolet radiation source accordingly.

In yet another aspect, the present invention relates to a method for performing extreme ultraviolet lithography, the method comprising the use of a mask as described in the first aspect. Further features of such a method may comprise steps corresponding to the features of the corresponding extreme ultraviolet lithography system described in the second aspect. By way of illustration, embodiments of the present invention not being limited thereto, a number of standard and optional features or method steps will now be described using a number of examples.

Example: extreme ultraviolet lithography mask

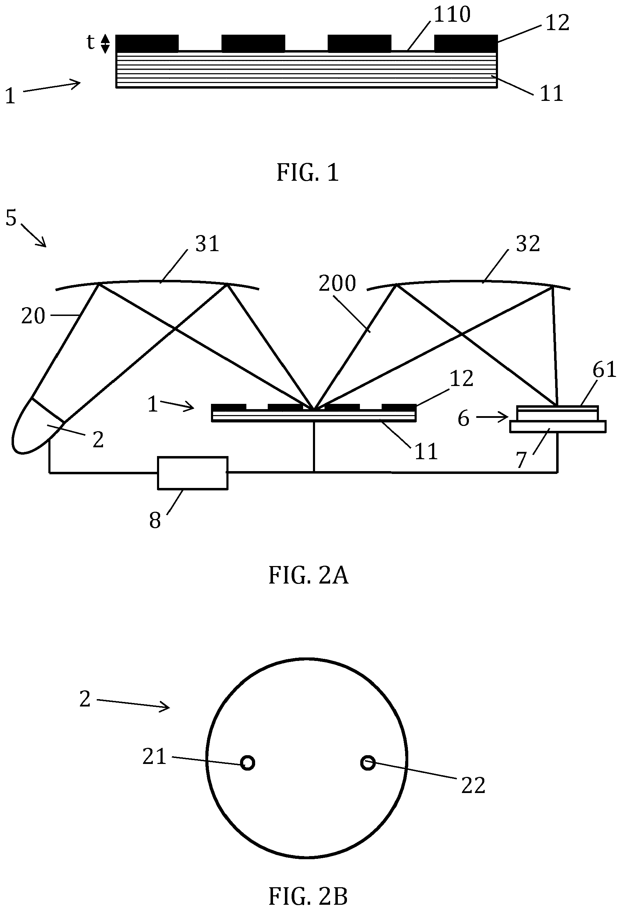

Reference is made to FIG. 1, which is a schematic representation of a vertical cross-section of an extreme ultraviolet lithography mask 1 in accordance with embodiments of the first aspect of the present invention. The extreme ultraviolet lithography mask 1 comprises a multi-layer reflector 11 for reflecting extreme ultraviolet radiation incident onto a top surface 110 of the multi-layer reflector 11. The multi-layer reflector 11 comprises multiple layers of alternating materials with different refractive index, and effectively acts as a Bragg reflector.

The extreme ultraviolet lithography mask 1 further comprises a patterned absorber layer 12 positioned on or over the multi-layer reflector 11, on or over said top surface 110. The patterned absorber layer 12 has a thickness t, in a direction normal to the top surface 110 of the multi-layer reflector 11, between 15 to 35 nm. Said thickness may be determined by, for example, scanning electron microscopy, such as cross-section scanning electron microscopy, or atomic force microscopy.

The patterned absorber layer 12, i.e., the material of which the patterned absorber layer 12 is formed, has a refractive index of at most 0.93. The refractive index may be determined using extreme ultraviolet reflectometry. For example, the extreme ultraviolet reflectometry technique described in Ciesielski, Richard, et al. "Determination of optical constants of thin films in the EUV." Applied Optics 61.8 (2022): 2060-2078 may be used to determine the refractive index of the material. For example, the model described therein (which corrects for any experimental parameters) may be used to derive the refractive index of the material from extreme ultraviolet reflectometry experiments. The experimental details may correspond to those described therein (with the materials mentioned therein replaced with the material of which the refractive index is to be determined), but that is not necessary, as the model corrects for any experimental parameters that may vary between different experiments. For example, the refractive index may be determined at a wavelength between 5 and 40 nm, e.g. at a wavelength of 13.5 nm, which is often used for extreme ultraviolet lithography.

As used herein, the refractive index as used within the context of the present invention refers to the real part of the refractive index corresponding to refraction (thus ignoring, in case of a complex-valued refractive index, the imaginary part that corresponds to the extinction coefficient).

Example: extreme ultraviolet lithography setup

Reference is made to FIG. 2A, which is a schematic representation of an extreme ultraviolet lithography setup 5 in accordance with embodiments of the second aspect of the present invention. The extreme ultraviolet lithography setup 5 comprises an extreme ultraviolet lithography mask 1 in accordance with embodiments of the first aspect of the present invention. The extreme ultraviolet lithography setup 5 may implement a method in accordance with embodiments of the third aspect of the present invention.

In the example illustrated, extreme ultraviolet radiation 20 from a multipolar extreme ultraviolet radiation source 2 is directed, via optical components 31, towards the extreme ultraviolet lithography mask 1. The extreme ultraviolet radiation 20 incident on the mask 1 is reflected by the mask 1. As known by the skilled person, the reflected extreme ultraviolet radiation 200 comprises radiation reflected and/or diffracted by the mask 1 at different diffraction orders, including, e.g., the zeroth diffraction order (i.e., radiation that is not diffracted) and radiation diffracted at the first diffraction order.

The reflected radiation 200, reflected by the mask 1, is collected by projection optics 32 and directed onto a photoresist 61 of a substrate 6 located on a table 7 of the extreme ultraviolet lithography setup 5, so that an image of the pattern of the patterned absorber layer 12 of the mask 1 is projected on the photoresist 61. The photoresist 61 is sensitive towards the extreme ultraviolet radiation 200, so that the pattern of the patterned absorber layer 12 of the mask 1 may be patterned into the photoresist 61. Said patterning may comprise simultaneously translating the mask 1 and the substrate 6 to consecutively transfer a different portion of the pattern of the mask 1 into the substrate 6. Said translation may, for example, be implemented using a controller 8.

Although the optical components 31 and the projection optics 32, in this example, are, in FIG. 2A, each simplistically represented as a single concave mirror, the invention is not limited thereby.

Simultaneous reference is made to FIG. 2B, which is a front view of the multipolar extreme ultraviolet radiation source 2, which is, in this example, a dipolar extreme ultraviolet radiation source 2. The extreme ultraviolet radiation source 2 emits extreme ultraviolet radiation, which may be radiation at a wavelength in the range between 5 and 40 nm, preferably at a wavelength of 13.5 nm, which is often used for extreme ultraviolet lithography. The multipolar extreme ultraviolet radiation source 2 comprises, or may be decomposed into, a plurality of poles 21 and 22, or monopoles 21 and 22, each generating extreme ultraviolet radiation having a different polarization state. Furthermore, as may be observed, the poles 21 and 22 are spatially shifted with respect to each other. Due to the different polarization states of radiation emitted by the different poles 21 and 22, and - as a result of their spatial shift with respect to each other - the different angle of incidence of radiation from the different poles 21 and 22 onto the mask 1, combined with the nonzero thickness of the patterned absorber layer 12 of the mask 1, and the different paths taken by radiation from the different poles 21 and 22 through the multilayer reflector 11 of the mask 1, mask 3D effects and hence imperfections in the diffraction pattern may occur. This may result, amongst others, in monopole diffraction amplitude imbalances, pole-to-pole phase offsets or image shifts, and pole-to-pole aerial image amplitude imbalance.

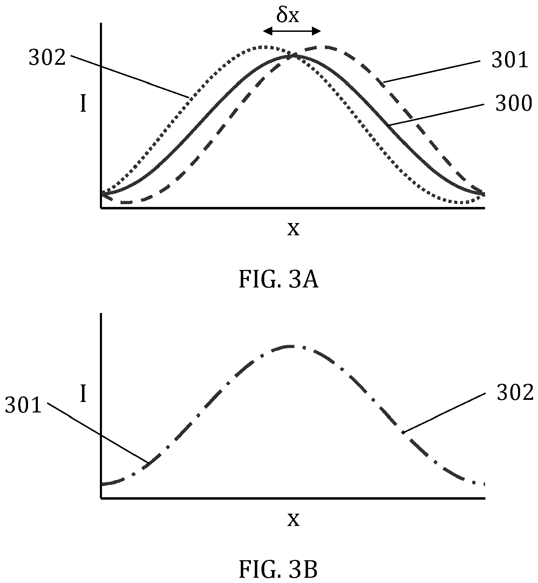

Simultaneous reference is made to FIG. 3A, wherein aerial images of the absorber layer 12 projected on the photoresist 61 are plotted, as an intensity of the radiation as a function of position on the photoresist 61. The pole-to-pole phase offsets typically result in a shift $\delta x$ between an (aerial) image 301 generated by radiation from a first pole 21 onto the photoresist 61 and an (aerial) image 302 generated by radiation from a second pole 22 onto the photoresist 61.

When, different from the present invention, illumination is performed using multipolar, e.g., dipolar, illumination, without compensation for this image shift $\delta x$, the actual (aerial) image 300 formed on the photoresist 61 is a combination of the images 301 and 302 shifted $\delta x$ with respect to each other. The actual image 300 thus formed, is, therefore, broadened compared to the individual images 301 and 302, which would be generated by each pole 21 and 22 individually, resulting in a reduction in contrast.

In the present invention, the image shift $\delta x$ is compensated for. There are several ways known in the art to compensate for this image shift $\delta x$ between images 301 and 302 generated by different poles 21 and 22.

As a first example, the split pole exposure technique can be used to compensate for these image shifts $\delta x$.

In short, in the split pole exposure technique, different poles 21, 22, or different sets of at least one pole 21, 22, of the multipolar extreme ultraviolet radiation source 2, are consecutively exposed. The controller 8 may control the extreme ultraviolet radiation source 2 to perform said consecutive exposures. Between consecutive exposures of different poles 21, 22, or different sets of at least one pole 21, 22, an alignment of the radiation 200 with respect to the photoresist 61 may be optimized.

Concretely, in a first step, a first set of at least one pole (in the example illustrated, the first pole 21) may be first exposed (while other poles 22 of the source 2 are not exposed) to project a first image 301 of the pattern, or a particular portion of the pattern, of the absorber layer 12 onto the photoresist 61.

Then, in a second step, said exposure may be terminated, and components of the setup 5 may be moved or realigned. Said movement may be performed by the controller 8, and may comprise movement of, for example, the mask 1, the substrate 6, or the extreme ultraviolet source 2.

Said movement or realignment is performed so that, subsequently in a third step, when the second pole 22 is exposed (while the first pole 21 is not exposed), an alignment of the radiation 200 with respect to the photoresist 61 is optimized so that a second image 302 of the pattern, or said particular portion of the pattern, of the absorber layer 12 onto the photoresist 61 better overlaps with the first image 301 on the photoresist 61 than would be the case in absence of said movement or realignment. In other words, the movement or realignment is performed such that when the second pole 22 is exposed, a shift between the first image 301 and the second image 302 is smaller than the image shift $\delta x$ in absence of said movement or realignment. Preferably, said movement or realignment is performed such that the images produced by different poles, e.g., the first and second image, coincide, as shown in FIG. 3B (with the first image 301 being represented by the dots, and the second image 302 being represented by the stripes).

Although, in the example illustrated, a dipolar extreme ultraviolet source 2 is used, of which the first pole 21 and the second pole 22 are consecutively and individually exposed, the invention is not limited thereto. Indeed, the extreme ultraviolet source 2 may be any type of multipolar extreme ultraviolet source 2, wherein, in the first step, a set of at least one pole 21, 22 of the multipolar extreme ultraviolet source 2 may be exposed, and, after the second step of said movement or realignment, in the third step, another set of at least one pole 21, 22 of the multipolar extreme ultraviolet source 2 may be exposed. The extreme ultraviolet source 2 may comprise more than two sets of at least one pole 21, 22, which may be consecutively exposed, wherein said movement or realignment may be performed between each two consecutive exposures.

As a second example, the setup 5 being adapted for compensating for said image shift $\delta x$ may comprise adaptation of the extreme ultraviolet radiation source 2. For example, the source 2 may be provided with an adapted pupil shape, and the radiation 20 from the source 2 may be provided with an aberration. Said aberration may be introduced by the extreme ultraviolet radiation source 2 being asymmetric by design. In this second example, by adapting the pupil shape of the source 2 and introducing an aberration accordingly, pole-specific phase errors, resulting in the image shifts $\delta x$, may be partially mitigated, while all poles 21, 22 of the multipolar extreme ultraviolet radiation source 2 may be exposed at the same time, which may simplify lithography. For example, adapting or optimizing the source 2 may comprise determining an image shift $\delta x$ between different poles 21, 22 of the source 2, and modifying the source 2 to reduce the determined image shift $\delta x$. Said adapting or optimizing the source 2 is typically performed when designing the setup 5. In this example, the extreme ultraviolet radiation source 2 may be adapted so that the shift $\delta x$ between images of the different poles 21, 22 is reduced compared to the image shift $\delta x$ that would be present when a symmetric pupil and a symmetric extreme ultraviolet radiation source without aberration would be used instead.

Example: Simulating loss of contrast for different absorbers

Mask absorber material and thickness optimization may be performed to restore imperfect diffraction originating from mask 3D effects. Indeed, the magnitude of the effect that compensating for pole-to-pole phase offsets or image shifts may have on the contrast, depends on the properties of the absorber layer of the extreme ultraviolet lithography mask that is used. The mask in accordance with embodiments of the first aspect of the present invention is optimized so that a particularly good contrast may be achieved when a lithography technique is applied that compensates for said image shifts.

When performing lithography using a multipolar extreme ultraviolet radiation source, three mechanisms may give rise to imperfections in the diffraction pattern:

- monopole diffraction amplitude imbalances (also known as $a_1/a_0$ imbalance)
- pole-to-pole phase offsets (also known as P2P shifts), or said image shifts between images formed by different poles
- pole-to-pole aerial image amplitude imbalance (which are negligible and further ignored here).

Optimizing the absorber layer material in terms of optical properties (refractive index and extinction coefficient) may suppress mask 3D effects. Furthermore, optimizing the absorber layer material may enable developing extreme ultraviolet lithography masks that may be used at a reduced extreme ultraviolet radiation dose that is necessary to complete a lithography step compared to the dose used in the state of the art, thereby increasing the throughput of an extreme ultraviolet scanner. However, to obtain such advantages of optimized absorber materials, also the absorber thickness must be carefully optimized.

The inventors have investigated important imaging metrics to select optimal features for the absorber layer. In particular, the features of the absorber layer in accordance with embodiments of the present invention is optimized so that the impact of mask 3D effects onto the lithography steps is small, and furthermore, so that the exposure dose needed that is necessary to complete a lithography step is small.

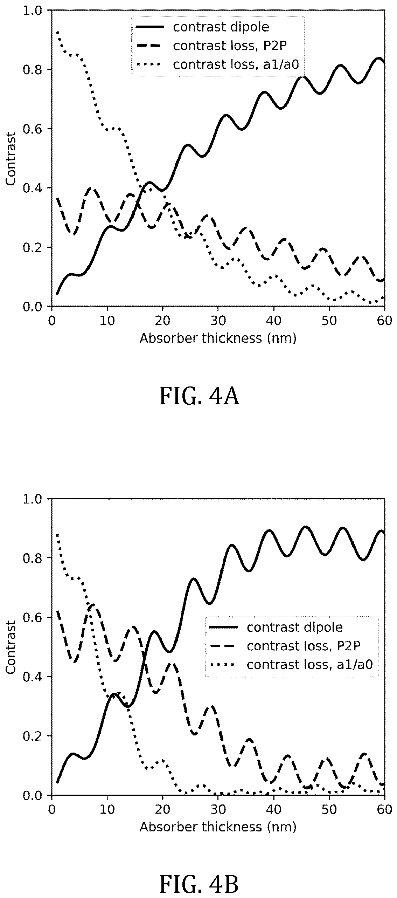

Simulations were performed for exposure of a dipolar extreme ultraviolet source, in particular, for generic leaf shape dipole illumination (pupil fill ratio = 20%), and for P28 vertical lines and spaces, half pitch mask CD at high-NA imaging (NA=0.55). FIG. 4A is a plot of the contrast (full line) achieved for a mask having an absorber layer formed of Ta, i.e., tantalum, having a refractive index of 0.95 at a wavelength of 13.5 nm. FIG. 4B is a plot of the contrast (full line) achieved for a mask having an absorber layer that if formed of an absorber material having a refractive index of 0.90. In both FIG. 4A and FIG. 4B, the dashed line represents contrast loss that is due to said image shifts resulting from pole-to-pole phase offsets, and the dotted line represents contrast loss that is due to monopole diffraction amplitude imbalances.

As may be observed in FIG. 4A, for absorber layers formed of Ta, both the image shifts and the monopole diffraction amplitude imbalance mechanism contribute to a reduction in contrast, and an optimal absorber thickness (at which the contrast is high) is found to be in the range of between 60 and 70nm.

However, as may be observed in FIG. 4B, in the case of the low-n absorber, when the absorber thickness is larger than approximately 15 nm, the driver for imperfections in the diffraction pattern may be predominantly attributed to the image shifts. From these simulations it does appear that, when performing lithography using a dipolar radiation source, without compensating for said image shifts or pole-to-pole phase offsets, reducing the refractive index of the absorbed layer compared to the refractive index of Ta will only result in a good contrast when the thickness of the patterned absorbed layer is above about 35 to 50 nm.

However, thinner (below 35 nm) low n mask absorber layers have the potential to significantly lower the exposure dose of a lithography step and are therefore preferred. Although, when using a dipolar radiation source, it appears that the contrast is only large for thicker low n mask absorber layers, from the simulations, it further appears that the high contrast is to a large extent attributable to image shifts between different poles. Indeed, for absorber thicknesses larger than about 15 nm, the contribution of monopole diffraction amplitude imbalances is rather limited. Hence, from these simulations, it appears that, when applying a lithography technique that compensates for image shifts between images formed by different poles, and when using a mask in accordance with embodiments of the present invention, having an absorber layer having a thickness of from 15 to 35 nm combined with a low refractive index, the contrast that may be achieved in lithography may be good.

Example: Split pole exposure using a mask having a low-n absorber

Simulations were performed to assess the effect of, in particular, the split pole exposure technique described previously, to compensate for image shifts between images formed by different poles, on the contrast that may be achieved in lithography using masks having low-n absorbers.

The simulations were performed for both dipole and monopole radiation (pupil fill ratio =10%) for P20 vertical lines and spaces, half pitch mask CD at high-NA imaging (NA=0.55). Said monopole radiation may be a result of a split pole exposure technique using a dipolar source, wherein the two monopoles of the dipolar source are exposed one at a time.

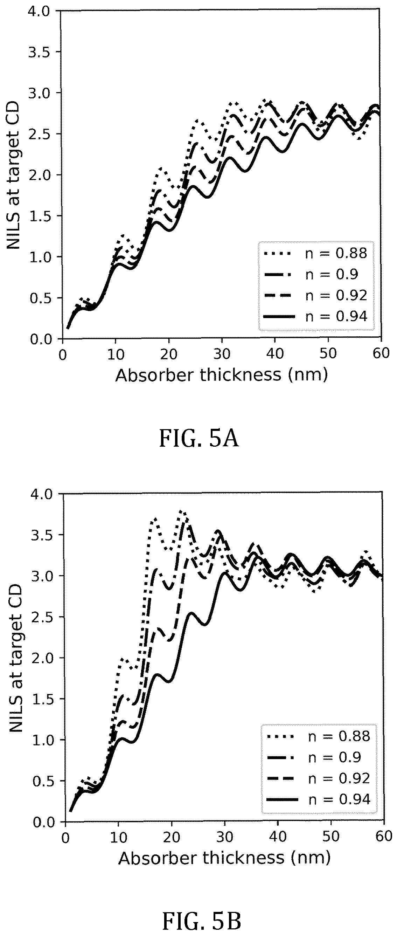

Reference is made to FIG. 5A and FIG. 5B, which are plots of the simulated NILS (normalized image log-slope, which is a metric for the contrast, with higher NILS indicating a sharper image) as a function of the absorber layer thickness, for a range of refractive indexes, for the dipolar radiation in the case of FIG. 5A, and for the monopolar radiation in the case of FIG. 5B. Simulations were performed for masks comprising an absorber layer formed of materials having refractive indexes in the range of from 0.88 to 0.95.

As was clear from FIG. 4B discussed above, imperfect diffraction for low-n absorber layers having a thickness in the range of from 15 to 35 nm is caused predominantly by large image shifts, which can be compensated for, or even eliminated, by the split pole exposure technique. Therefore, in the case of low n absorber layers, the absorber layer thickness can be further reduced, resolving the technical problems as explained above, and significant imaging benefits can be realized.

As shown in FIG. 5A, when using dipolar radiation of P20V lines and spaces, even for low-n materials, i.e., materials having a low refractive index n, an absorber thickness of from 35 to 40 nm (where the NILS is largest) is preferably used to prevent contrast fading due to mask 3D effects.

In contrast, as is shown in FIG. 5B, in the case of monopole exposure, as used in the split pole exposure technique, for low-n absorber materials, the thickness can be reduced to between 15 and 35 nm. Indeed, as may be observed in FIG. 5B, when the absorber layer has a refractive index of at most 0.93, the simulations unexpectedly predict a good NILS for absorber layers having a thickness between 15 and 35 nm, in particular compared with the NILS for thicker low-n absorbers.

A reduction in thickness results in a linearly more reflective absorber. Therefore, for an absorber layer formed of a low-n material and having a thickness of from 15 to 25 nm, the exposure dose is expected to be reduced by 62.5%-37.5%, respectively, while also achieving a contrast improvement of ~30% for P20V lines and spaces, compared to low-n mask layers of the state of the art having a thickness of 40 nm when using dipole illumination.

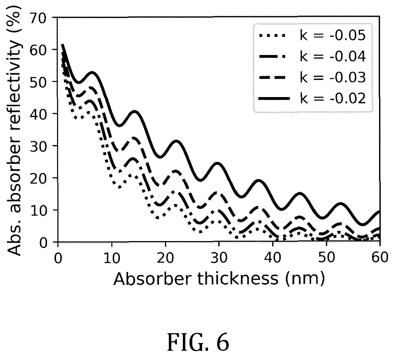

In case of a thin absorber layer, the absorber reflectivity can be much higher than the reflectivity of regular low n masks, namely up to 35% higher. As shown in FIG. 6, by tuning the absorber material extinction coefficient k, however, the absorber reflectivity can be tuned from 30% to 8% for an exemplary absorber layer having a refractive index of 0.90 and a thickness of 22 nm.

Overall, from the simulations, it appears that a particularly large imaging benefit can be obtained when a split pole exposure technique is combined with a mask in accordance with embodiments of the present invention.

However, combining the mask in accordance with embodiments of the present invention with other techniques for reducing the pole-to-pole phase shift is expected to also result in a good contrast. Nevertheless, due to the angle-specific nature of mask 3D effects (which are significant for thin, low n masks), which can be best compensated for by the split pole exposure technique, the contrast may be expected to be best optimized when using the split pole exposure technique.

It is to be understood that although preferred embodiments, specific constructions and configurations, as well as materials, have been discussed herein for devices according to the present invention, various changes or modifications in form and detail may be made without departing from the scope of this invention. Steps may be added or deleted to methods described within the scope of the present invention.

## Claims

1. An extreme ultraviolet lithography mask (1), the mask (1) comprising:

   - a multi-layer reflector (11), and
   - a patterned absorber layer (12) positioned over the multi-layer reflector (11),

   wherein the absorber layer (12) has a thickness (t) between 15 to 35 nm and a refractive index of at most 0.93.

2. The extreme ultraviolet lithography mask (1) of claim 1, wherein the absorber layer (12) has a thickness between 15 to 30 nm.

3. The extreme ultraviolet lithography mask (1) of any of the previous claims, wherein the absorber layer (12) is formed of Pt, PtMo, $Pt_2Mo$, RuTa, RusTa, Mo, or RusRe.

4. The extreme ultraviolet lithography mask (1) of any of the previous claims, wherein the refractive index is between 0.85 to 0.93.

5. An extreme ultraviolet lithography setup (5), comprising:

   the extreme ultraviolet lithography mask (1) according to any of claims 1 to 4,
   a multipolar extreme ultraviolet radiation source (2), and
   a table (7) for holding a substrate (6) comprising a photoresist (61) to be patterned,
   wherein the setup (5) is configured for exposing poles (21, 22) of the multipolar extreme ultraviolet radiation source (2), so that extreme ultraviolet radiation (20) from each pole (21, 22) is reflected by the mask (1) to form an image (300, 301, 302) of the absorber layer pattern on the photoresist (61), when present, to pattern the photoresist (61), and

wherein the setup (5) is adapted for compensating for an image shift ($\delta$x) between images (301, 302) formed by different poles (21, 22), said image shift ($\delta$x) resulting from a different angle of incidence and/or polarity of the extreme ultraviolet radiation (20) from different poles (21, 22) onto the mask (1).

6. The extreme ultraviolet lithography setup (5) according to claim 5, the multipolar extreme ultraviolet radiation source (2) being adapted for controlling the irradiation intensity to be within 0.8 times and 1.0 times $I_0$, with $I_0$ being given by:

$$I_0 = I_{conventional\ absorber\ thickness} \cdot \exp\left[\frac{8\pi k}{\lambda}\left(t_{absorber} - t_{absorber,conventional}\right)\right].$$

7. A method of patterning a photoresist (61), the method comprising:

performing lithography by exposing poles (21, 22) of an extreme ultraviolet radiation source (2), so that extreme ultraviolet radiation (20) from each pole (21, 22) is reflected by the extreme ultraviolet lithography mask (1) according to any of claims 1 to 4 to form an image (300, 301, 302) of the absorber layer pattern on a photoresist (61) to pattern the photoresist (61),

the method comprising compensating for an image shift ($\delta$x) between images (300, 301, 302) formed by different poles (21, 22), said image shift ($\delta$x) resulting from a different angle of incidence and/or polarity of the extreme ultraviolet radiation from different poles (21, 22) onto the mask (1).

8. The method according to claim 7, wherein performing lithography comprises performing split pole exposure lithography, comprising consecutively exposing a different set of at least one pole (21, 22) of the multipolar extreme ultraviolet radiation source (2),

said compensating for said image shift ($\delta$x) comprising optimizing an alignment of the radiation (200) with respect to the photoresist (61) between consecutive exposures.

9. The method according to claim 8, wherein optimizing said alignment comprises shifting a position of the mask (1) between consecutive exposures of different poles (21, 22).

10. The method according to any of claims 7 to 9, wherein said extreme ultraviolet radiation (20) is incident onto the mask (1) at an intensity of between 0.8 times and 1.0 times $I_0$, with $I_0$ being given by:

$$I_0 = I_{conventional\ absorber\ thickness} \cdot \exp\left[\frac{8\pi k}{\lambda}\left(t_{absorber} - t_{absorber,conventional}\right)\right].$$

11. The method according to any of claims 7 to 10, wherein said image shift ($\delta$x) results from mask 3D effects.

FIG. 1

FIG. 2A

FIG. 2B

FIG. 3A

FIG. 3B

FIG. 4A

FIG. 4B

FIG. 5A

FIG. 5B

FIG. 6

Europäisches
Patentamt

European
Patent Office

Office européen
des brevets

# EUROPEAN SEARCH REPORT

Application Number

EP 23 20 9193

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/011121 A1 (YU SHINN-SHENG [TW] ET AL) 9 January 2014 (2014-01-09) | 1-4 | INV. G03F1/24 |
| A | * abstract * * figures 1-3 * * paragraphs [0008], [0016] - [0022] * | 5-11 | G03F1/54 G03F7/20 |
| A | WO 2023/190696 A1 (TOPPAN PHOTOMASK CO LTD [JP]) 5 October 2023 (2023-10-05) * abstract * * figure 4 * | 1-11 | |
| A | FRANKE JOERN-HOLGER ET AL: "Dual monopole exposure strategy to improve extreme ultraviolet imaging", JOURNAL OF MICRO/NANOPATTERNING, MATERIALS, AND METROLOGY, vol. 21, no. 3, 20 July 2022 (2022-07-20), pages 030501-1-030501-7, XP060164759, ISSN: 1932-5150, DOI: 10.1117/1.JMM.21.3.030501 [retrieved on 2022-07-20] * the whole document * | 1-11 | |
| A | BURKHARDT MARTIN: "Investigation of alternate mask absorbers in EUV lithography", PROCEEDINGS OF SPIE; [PROCEEDINGS OF SPIE ISSN 0277-786X VOLUME 10143], SPIE, US, vol. 10143, 27 March 2017 (2017-03-27), pages 1014312-1014312, XP060088033, DOI: 10.1117/12.2258266 ISBN: 978-1-5106-1533-5 * the whole document * | 1-11 | |

TECHNICAL FIELDS SEARCHED (IPC)

G03F

The present search report has been drawn up for all claims

| Place of search | Date of completion of the search | Examiner |
|---|---|---|
| Munich | 2 May 2024 | Andersen, Ole |

EPO FORM 1503 03.82 (P04C01)

## ANNEX TO THE EUROPEAN SEARCH REPORT
## ON EUROPEAN PATENT APPLICATION NO.

EP 23 20 9193

This annex lists the patent family members relating to the patent documents cited in  the above-mentioned European search report.
The members are as contained in the European Patent Office EDP file on
The European Patent Office is in no way liable for these particulars which are merely given for the purpose of information.

02-05-2024

| Patent document cited in search report | Publication date | Patent family member(s) | | Publication date |
|---|---|---|---|---|
| US 2014011121 A1 | 09-01-2014 | CN | 103529640 A | 22-01-2014 |
| | | US | 2014011121 A1 | 09-01-2014 |
| WO 2023190696 A1 | 05-10-2023 | TW | 202347008 A | 01-12-2023 |
| | | WO | 2023190696 A1 | 05-10-2023 |

EPO FORM P0459

For more details about this annex : see Official Journal of the European Patent Office, No. 12/82

**EP 4 553 575 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- Improving exposure latitudes and aligning best focus through pitch by curing M3D phase effects with controlled aberrations.. **FRANKE, JOERN-HOLGER et al.** International Conference on Extreme Ultraviolet Lithography. SPIE, 2019, vol. 11147

- **FRANKE, JOERN-HOLGER ; TIMOTHY A. BRUNNER ; ERIC HENDRICKX**. Dual monopole exposure strategy to improve extreme ultraviolet imaging.. *Journal of Micro/Nanopatterning, Materials, and Metrology*, 2022, vol. 21 (3), 030501-030501
- **CIESIELSKI, RICHARD et al.** Determination of optical constants of thin films in the EUV.. *Applied Optics*, 2022, vol. 61 (8), 2060-2078